# EUROPÄISCHE PATENTSCHRIFT

(11) **EP 2 606 002 B1**
(45) Veröffentlichungstag und Bekanntmachung des Hinweises auf die Patenterteilung: **05.12.2018**
(21) Anmeldenummer: 11725010.0
(22) Anmeldetag: 23.05.2011
(51) Int. Cl.: B81B 3/00, G01N 27/12, G01N 27/14

(54) **MIKROMECHANISCHES SUBSTRAT FÜR MEMBRAN MIT DIFFUSIONSSPERRSCHICHT**
MICROMECHANICAL SUBSTRATE FOR A DIAPHRAGM WITH A DIFFUSION BARRIER LAYER
SUBSTRAT MICROMÉCANIQUE POUR MEMBRANE À COUCHE BARRIÈRE DE DIFFUSION

(30) Priorität: 30.09.2010 DE 102010041763
(43) Veröffentlichungstag der Anmeldung: 26.06.2013
(73) Patentinhaber: Siemens Aktiengesellschaft, 80333 München (DE)
(72) Erfinder: FLEISCHER, Maximilian, 85635 Höhenkirchen (DE); HEDLER, Harry, 82110 Germering (DE); WIESNER, Kerstin, 85640 Putzbrunn (DE); ZAPF, Jörg, 81927 München (DE); FREUDENBERG, Oliver, 81739 München (DE); SCHIEBER, Markus, 80469 München (DE); SCHREINER, Manfred, 82131 Gauting (DE); WEIDNER, Karl, 81245 München (DE)
(86) Internationale Anmeldenummer: PCT/EP2011/058325
(87) Internationale Veröffentlichungsnummer: WO 2012/041539

(56) Entgegenhaltungen:
- WO-A1-00/57151
- US-A- 5 525 549

## Beschreibung

Die Erfindung betrifft ein mikromechanisches Substrat mit einer Membran sowie ein Verfahren zu seiner Herstellung, wobei die Membran insbesondere Träger für Elemente eines Sensors ist.

Gassensoren finden in modernen technischen Anlagen eine zunehmende Verbreitung. Ein Beispiel dafür ist ein Lecksensor, der das Auftreten eines einzelnen Gases detektiert. Ein weiteres Beispiel ist ein Abgassensor, der ein Gemisch aus mehreren Gaskomponenten analysiert. Ein drittes Beispiel ist ein Gassensor für die Branderkennung. Ein weiteres Einsatzfeld für Gassensoren findet sich in der Atemgasanalyse. Dort kann beispielsweise das Vorhandensein von Alkoholen detektiert werden oder das Vorhandensein von Stickstoffmonoxid (NO) für Asthmapatienten.

Aufgrund ihres einfachen Aufbaus und einer langen Lebensdauer haben Gassensoren auf Basis halbleitender Metalloxide eine hohe Bedeutung. Das klassischerweise verwendete Metalloxid ist das Zinndioxid (SnO₂), manchmal auch WO₃. Oftmals werden aber auch andere Metalloxide sowie Mischungen aus verschiedenen Metalloxiden sowie getragene Katalysatordispersionen zur Verbesserung der Sensoreigenschaften verwendet.

Metalloxidsensoren müssen im Allgemeinen zum Betrieb beheizt werden. Die ersten Sensoraufbauten verwendeten dazu ein Keramikröhrchen mit innen liegender Heizwicklung als Träger. Moderne planare Aufbauten verwenden ein üblicherweise keramisches Substrat, auf dem auf der Rückseite eine elektrische Heizstruktur, beispielsweise ein Platin Heizmäander angebracht ist und auf der Vorderseite eine Elektrodenstruktur zur Messung des Widerstands der halbleitenden Sensorschicht. Das keramische Substrat ist dann mittels Drähtchen (üblicherweise aus Platin) in einem Gehäuse aufgehängt.

Diese Aufbautechnologie ist aber kostenintensiv und aufwändig, da teilweise Handarbeit. Um den Aufwand zu senken, wurden für die SnO₂-Sensoren mikromechanische Aufbauten entwickelt, bei denen sich die funktionalen Elemente des Sensors auf einer im Mikrometerbereich dicken, also sehr dünnen Membran befinden. Dieser Aufbau kann nun kostengünstig direkt auf ein Gehäuse oder ein PCB geklebt werden, da die Membran eine hohe thermische Isolation gegen die Umgebung hat und der Silizium-Träger somit trotz beheizter Membran praktisch Raumtemperatur aufweist. Die Kontaktierung erfolgt kostengünstig mittels Al- oder Au-Drahtbonden.

Die verwendete Membran kann beispielsweise als Siliziumnitridmembran realisiert werden. Zur Herstellung wird vereinfacht gesagt ein Siliziumwafer mit dem Siliziumnitrid beschichtet und ein Teil des Siliziumwafers sodann mit einer Volumenätzung entfernt. Aus der EP 0 953 152 B1 ist die Herstellung eines Membransubstrats unter Verwendung eines Silicon-on-Insulator-Wafers (SOI) bekannt.

Das Metalloxid SnO₂ kann auf den bekannten Membranen gut eingesetzt werden, weist aber eine ganze Reihe von Nachteilen auf wie beispielsweise:
- große Exemplarstreuung der sensitiven Eigenschaften,
- langes Einlaufverhalten nach jedem Einschalten,
- mangelnde Stabilität im Abgas.

Wesentliche Verbesserungen in allen diesen Eigenschaften weisen neuere Metalloxide wie das Galliumoxid (Ga2O3) auf, beispielsweise beschrieben in M. Fleischer, "Advances in Application Potential of Solid State Gas Sensors: High-Temperature Semiconducting Oxides and Ambient Temperature GasFET Devices", Measurement Science and Technology 19 (2008), 1-18. Dieses Material muss allerdings bei Temperaturen von 650-900°C betrieben werden. Die bekannten mikromechanischen Aufbauten mit einer Membran sind dafür aufgrund mangelnder Temperaturstabilität nicht geeignet, da die kontinuierliche Umwandlung von Zug in Druckspannungen zu Membranbruch führt. Beispielsweise wird bei der EP 0 953 152 B1 wird zur Beheizung des Substrats eine CMOS-kompatible Heizerstruktur verwendet, die ebenfalls nicht geeignet ist für solche Temperaturen.

In der Offenlegungsschrift WO 00/57151 A1 wird ein Substrataufbau gemäß dem Oberbegriff der unabhängigen Patentansprüche offenbart.

Auch die Patentschrift US 552549 A offenbart einen Substrataufbau ähnlich dem Oberbegriff der unabhängigen Patentansprüche, wobei über die Dicke der Membran keine Offenbarung vorliegt.

Es ist Aufgabe der vorliegenden Erfindung, einen Substrataufbau anzugeben, der deutlich über 650°C hinaus temperaturstabil ist. Eine weitere Aufgabe besteht darin, ein Verfahren zur Herstellung eines solchen Substrataufbaus anzugeben.

Die Aufgabe wird durch einen Substrataufbau mit den Merkmalen von Anspruch 1 gelöst. Hinsichtlich des Herstellungsverfahrens wird die Aufgabe durch ein Verfahren mit den Merkmalen von Anspruch 7 gelöst.

Der erfindungsgemäße Substrataufbau umfasst ein Substrat, das wenigstens zwei separate einkristalline Siliziumschichten aufweist. Das Substrat weist weiterhin in einem Teilbereich eine Membran auf, wobei die Dicke der Membran weniger als 200 µm beträgt. Die Membran umfasst einen Teil einer ersten der einkristallinen Siliziumschichten.

Schließlich umfasst das Substrat wenigstens eine Diffusionssperrschicht jeweils auf Ober- und Unterseite der ersten einkristallinen Siliziumschiht zur Verminderung der Oxidation der ersten einkristallinen Siliziumschicht. Die Diffusionssperrschicht bedeckt dabei wenigstens die Membran. Dabei kann die Diffusionssperrschicht direkt auf der ersten Siliziumschicht liegen oder auch indirekt, d.h. getrennt durch andere Schichten.

Das Substrat weist neben den beiden einkristallinen Siliziumschichten wenigstens ein isolierendes Material wie Siliziumdioxid (SiO₂) oder Siliziumnitrid (Si₃N₄) auf, das die einkristallinen Siliziumschichten trennt. Das Substrat ist bevorzugt ein prozessierter SOI-Wafer.

Die zweite der einkristallinen Siliziumschichten bildet einen Trägerrahmen für den Substrataufbau. Hierdurch wird vorteilhaft eine erleichterte Herstellung der Membran gewährleistet, da Silizium einfach mit bekannten Ätz-Techniken zu bearbeiten ist.

Die Membran ist dünner als 200 µm und in einer weiteren Ausgestaltung der Erfindung dünner als 50 µm. Je dünner die Membran ist, desto geringer ist ihre Wärmekapazität. Bei geringer Wärmekapazität sind schnelle Temperaturwechsel möglich, was für einen Betrieb von beispielsweise Gassensoren auf dem Substrataufbau von Vorteil ist. Weiterhin ist bei einer dünneren Membran auch die Isolationsfähigkeit der Membran erhöht, was für eine gleichmäßigere Temperatur der Membran sorgt und damit deren interne mechanische Spannungen durch Temperaturgradienten vermindert. Für eine gewisse mechanische Festigkeit ist es wiederum von Vorteil, wenn die Membran dicker als 2 µm, insbesondere dicker als 20 µm ist.

Die Diffusionssperrschicht bedeckt wenigstens die Membran direkt oder indirekt. Die Diffusionssperrschicht vermindert den Zugang von Sauerstoff zur ersten der einkristallinen Siliziumschichten. Für die Erfindung wurde erkannt, dass eine Membran, die eine einkristalline Siliziumschicht umfasst, hohen Temperaturen besser widerstehen kann als bekannte Siliziumnitridmembranen, aber bei hohen Temperaturen oxidiert. Diese Oxidation reduziert die Lebensdauer eines solchen Aufbaus auf Werte von wenigen hundert Stunden bei annehmbaren Membrandicken, was zu wenig ist. Daher wird vorteilhaft mittels der Diffusionssperrschicht der Zugang von Sauerstoff zu wenigstens einem Teil der ersten der einkristallinen Siliziumschichten erschwert und so die Lebensdauer deutlich erhöht. Dadurch wird ein Membransubstrat geschaffen, das in der Lage ist, Temperaturen von mehr als 650°C standzuhalten. Dadurch wiederum wird der Einsatz von Gassensormaterialien, die erst bei solch hohen Temperaturen funktionieren, auf Membransubstraten ermöglicht.

Der Substrataufbau weist ferner ein Beheizungselement auf, das ausgestaltet ist, in wenigstens einem Teil der Membran eine Temperatur von mehr als 650°C zu erzeugen. Das Beheizungselement kann beispielsweise als elektrischer Widerstandsheizer realisiert sein. Solche Heizer werden beispielsweise unter Verwendung von mehr oder minder dicken Schichten aus strukturiertem Platin realisiert. Auch eine elektrische Heizung, die als Transistor realisiert ist, kann verwendet werden. Es ist in einer alternativen Ausgestaltung auch möglich, dass der Heizer abseits der Membran vorgesehen ist, beispielsweise als Strahlungsquelle, die auf die Membran gerichtet ist.

Die Diffusionssperrschicht umfasst bevorzugt eins oder mehrere der Materialien Platin, Platinsilizid, Siliziumnitrid und Siliziumkarbid. Diese Materialien sind bekanntermaßen hochtemperaturstabil und wenig durchlässig für Sauerstoff. SiO₂ hingegen ist nicht geeignet als Diffusionssperrschicht. Auch ein mehrschichtiger Aufbau mit mehreren Materialien kommt als Diffusionssperrschicht infrage.

In einer bevorzugten Ausgestaltung der Erfindung ist die Membran mit dem Rest des Substrats über Stege verbunden. Mit anderen Worten besteht keine vollständige Verbindung des Randes der Membran mit dem umgebenden Substrat, sondern es sind vielmehr Aussparungen vorhanden, die einen Teil des Randes der Membran vom restlichen Substrat entkoppeln und somit die Membran in Teilen frei schwebend machen. Hierdurch wird die Widerstandsfähigkeit der Membran gegen thermomechanische Belastungen erhöht, da die Membran eine größere Freiheit hat, sich beispielsweise zu strecken, ohne sich dabei deutlich verformen zu müssen.

Besonders vorteilhaft ist es, wenn die Stege eine Abwinkelung aufweisen oder mit anderen Worten, wenn die Stege ihre Laufrichtung in der Horizontalen ändern. Besonders vorteilhaft ist es, wenn die Stege ein langes Element aufweisen, das parallel zur Membranseitenkante verläuft und am Ende des langen Elementes eine Abwinkelung existiert, mittels derer der Steg mit der Membran verbunden ist. Über die langen Elemente wird erreicht, dass eine mechanische Belastung durch Ausdehnung der Membran bei einer hohen Betriebstemperatur besonders gut über eine leichte Drehung der Membran abgebaut werden kann.

Unter Verwendung des Substrataufbaus lässt sich vorteilhaft ein Gassensor aufbauen, indem dem Substrataufbau ein gassensitives Element hinzugefügt wird, das wenigstens zum Teil auf der Membran aufgebracht ist. Beispielsweise kann ein Metalloxid auf die Membran aufgebracht werden und der Widerstand des Metalloxids als Gasmesssignal ausgewertet werden.

Beim erfindungsgemäßen Verfahren zur Herstellung eines Substrataufbaus wird ein Substrat bereitgestellt, wobei das Substrat wenigstens zwei separate einkristalline Siliziumschichten aufweist. Beispielsweise kann hierfür ein SOI-Wafer verwendet werden. In einem Teilbereich des Substrats wird eine Membran erzeugt, deren Dicke weniger als 200 µm, insbesondere weniger als 50 µm beträgt, wobei die Membran einen Teil einer ersten der einkristallinen Siliziumschichten umfasst. Die andere einkristalline Siliziumschicht bildet einen Rahmen.

Schließlich wird wenigstens eine Diffusionssperrschicht jeweils auf Ober- und Unterseite der ersten einkristallinen Silkiziumschicht zur Verminderung der Oxidation der ersten einkristallinen Siliziumschicht erzeugt, wobei die Diffusionssperrschicht wenigstens die Membran bedeckt.

Außerdem wird ein Beheizungselement (15, 25) erzeugt, das ausgestaltet ist, in wenigstens einem Teil der Membran (33) eine Temperatur von mehr als 650°C zu erzeugen.

Bevorzugte, jedoch keinesfalls einschränkende Ausführungsbeispiele für die Erfindung werden nunmehr anhand der Figuren der Zeichnung näher erläutert. Dabei sind die Merkmale schematisiert dargestellt. Es zeigen
- Figur 1: einen Gassensoraufbau mit übereinander angeordnetem Heizelement und Gassensor,
- Figur 2: einen Gassensoraufbau mit nebeneinander angeordnetem Heizelement und Gassensor und
- Figur 3: eine Membranstrukturierung.

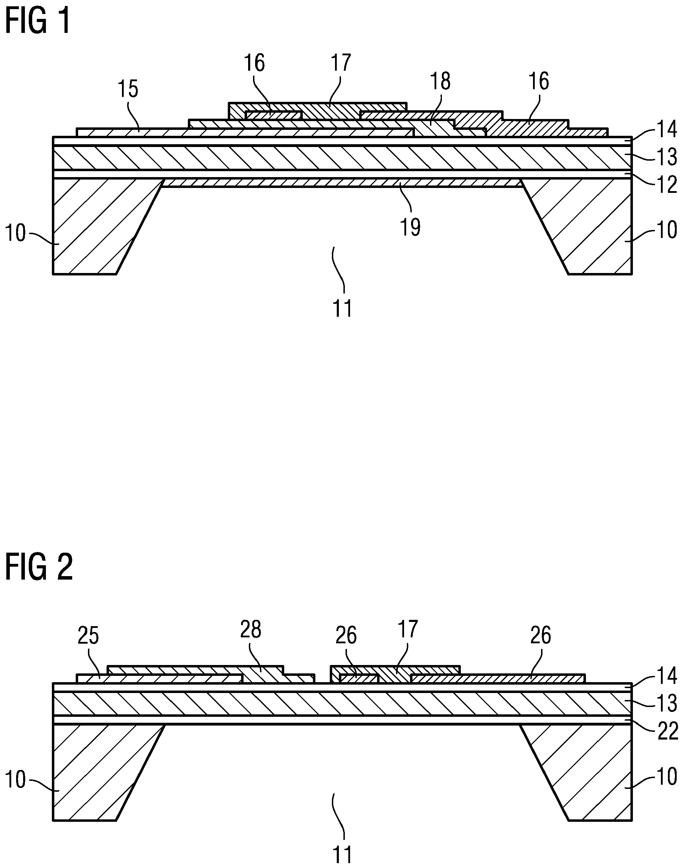

Figur 1 zeigt ein erstes Ausführungsbeispiel für einen Gassensor auf Galliumoxidbasis, der auf einem Membransubstrat realisiert ist. Figur 1 stellt dabei einen Schnitt durch den Gassensor und das Membransubstrat dar. Dabei ist die Darstellung nicht maßstabsgetreu, die meisten Dicken von Schichten sind weit überhöht dargestellt gegenüber den lateralen Ausdehnungen. Der Schnitt ist dabei weiterhin nicht vollständig dargestellt, da die Membran nicht durchgehend mit dem Rest des Substrats verbunden ist, und somit im Schnittbild Einschnitte zu sehen sein müssten. Diese wurden jedoch der besseren Übersicht wegen weggelassen.

Das Membransubstrat wird von einem Rahmen 10 aus einkristallinem Silizium getragen. Im Schnittbild der Figur 1 sind nur zwei abgeschrägte Stücke des Rahmens 10 erkennbar, diese bilden jedoch im ersten Ausführungsbeispiel einen durchgehenden Rahmen 10 um die Membran. Die Membran selbst wird durch eine Schichtfolge einer Isolationsschicht 12 aus Siliziumdioxid, einer Membranschicht 13 aus einkristallinem Silizium und einer oberen Diffusionssperrschicht 14 gebildet, die in diesem Beispiel aus Platinsilizid besteht. Unterhalb der Membran ist im Inneren des Rahmens 10 eine untere Diffusionssperrschicht 19 vorgesehen, die im ersten Ausführungsbeispiel ebenfalls aus Platinsilizid besteht. Die Schichtfolge bildet in dem Bereich, in dem der Rahmen 10 eine Aussparung 11 aufweist, die Membran. Die Dicke der Membran beträgt in diesem Beispiel 30 µm. Die Diffusionssperrschicht 14 dient gleichzeitig als Schicht zur elektrischen Isolation. Falls die Diffusionssperrschicht 14 selbst nicht ausreichend isolierend wirkt, kann beispielsweise eine weitere Schicht auf oder unter der Diffusionssperrschicht 14 erzeugt werden. Diese weitere Schicht besteht bevorzugt im Wesentlichen aus SiO₂ und/oder Al₂O₃. SiO₂ eignet sich hierfür besonders gut wegen einer guten Haftung zur Unterlage, einer einfachen Herstellung durch thermische Oxidation, weiterhin wegen der guten Stabilität bei hohen Temperaturen und auch wegen der nur geringen weiteren Oxidation bei weiteren Hochtemperaturprozessen.

Auf der Membran sind nun verschiedene Elemente untergebracht, die zusammen einen Gassensoraufbau bilden. Hierzu führt von einer Seite des Membransubstrats ausgehend von einem Bereich oberhalb des Rahmens 10 eine Heizerschicht 15 auf die Membran. Im Bereich der Membran ist die Heizerschicht 15 so strukturiert, dass ein Heizmäander gebildet ist. Der elektrische Widerstand ist im Bereich des Heizmäanders deutlich erhöht und eine elektrische Beheizung der Membran ist somit möglich. Die Heizerschicht 15 ist weiterhin im Bereich der Membran bedeckt von einer Isolationsschicht 18 aus Siliziumnitrid.

Der elektrische Heizer kann über den Temperaturgang des elektrischen Widerstandes auch als Temperatursensor verwendet werden. Die Heizerschicht 15 besteht bevorzugt aus Platin als Dünnschicht mit einer Dicke von beispielsweise zwischen 0,5 und 2 µm. Alternativ kann die Heizerschicht 15 auch beispielsweise aus harten Legierungen von Platinmaterialien, beispielsweise Pt/Rh 70/30 bestehen. Zur Vermeidung einer Heizungszerstörung durch Elektromigration sind bei der Heizerschicht 15 soweit möglich Ecken und kantige Übergange zu vermeiden und durch runde Strukturen zu ersetzen.

Von einer weiteren Seite des Membransubstrats her führen zwei Gassensorelektroden 16 auf die Membran und auf die Isolationsschicht 18. Die Gassensorelektroden 16 bilden im Bereich der Membran auf der Isolationsschicht 18 eine so genannte Interdigitalelektrodenstruktur, auch Fingerelektrodenstruktur genannt. Die Fingerelektroden weisen dabei typischerweise Abstände zwischen 5 und 30 µm auf. Auf der Fingerelektrodenstruktur ist eine Gassensorschicht 17 aus polykristallinem Galliumoxid aufgebracht. Eine solche Schicht wird üblicherweise mit einem Sputterverfahren mit Schattenmaske erzeugt. Die Schichtdicke der Ga₂O₃-Schicht beträgt bevorzugt zwischen 0,5 und 3 µm. In alternativen Ausführungsformen des Gassensors können statt dem Galliumoxid auch eine Reihe anderer Metalloxide verwendet werden, beispielsweise CeO₂, TiO₂, WO₃/TiO₂-Mischoxide, NiO, Chrom-Titan-Oxide (Cr₂₋ₓTiₓO₃, x≤0,5) und Materialien aus der Gruppe der Perowskite (SrTiO₃, BaTiO₃, temperaturunabhängige Cuprate wie LaCu₁₋ₓFeₓO_{3-y}).

Das gezeigte Substrat bildet einen hochtemperaturfesten Membranaufbau durch die Verwendung von einkristallinem Silizium als wesentlichem Membranmaterial und wie auch durch die Verwendung von Silizium als Material für den Rahmen 10. Dieses Material ist mit den Methoden der Mikrotechnologie gut bearbeitbar. Das Silizium als Membranmaterial gewährleistet neben ausreichender mechanischer Stabilität vor allem die benötigte Temperaturfestigkeit. Da das Material bereits im einkristallinen Zustand ist, kann bei hohen Temperaturen kein weiterer Aufbau von mechanischen Spannungen stattfinden, der zur Beeinträchtigung der Membranfunktion führen wurde.

Falls die Isolationsschicht zwischen Heizung und Struktur des Ga₂O₃ Sensors keine ausreichende Isolationsfähigkeit aufweist, wird sie bevorzugt vertikal durch ein Dreischichtsystem Isolator, flächige Pt-Elektrode, Isolator ersetzt, wobei die mittlere Elektrode auf Masse gelegt wird. Dadurch können Kriechstrome von der Heizung zum Ga₂O₃ Sensor abgeschirmt werden, die eine Verfälschung bei der Messung des Widerstands des Ga₂O₃ bewirken können.

Ein zweites Ausführungsbeispiel für ein Membransubstrat gemäß der Erfindung ist in Figur 2 dargestellt. Dabei gelten bezüglich der Darstellung die gleichen Einschränkungen wie bei der Figur 1, so ist die Darstellung unter anderem nicht maßstabsgetreu.

Wie beim Membransubstrat gemäß dem ersten Ausführungsbeispiel wird das Substrat von einem Rahmen 10 aus einem kristallinen Silizium getragen. Gegenüber dem ersten Ausführungsbeispiel ist jedoch die Schichtfolge, die die Membran bildet, verändert. So wird im zweiten Ausführungsbeispiel die Membran von einer Isolations- und Diffusionssperrschicht 22 aus Siliziumnitrid, der Membranschicht 13 aus einkristallinem Silizium und der oberen Diffusionssperrschicht 14 gebildet. Da im zweiten Ausführungsbeispiel die Isolatorschicht zwischen den einkristallinen Schichten des Rahmens 10 und der Membranschicht 13 bereits von Siliziumnitrid gebildet wird, ist eine zusätzliche Diffusionssperrschicht unterhalb der Membran unnötig. Im ersten Ausführungsbeispiel ist die Isolatorschicht hingegen durch eine Siliziumdioxidschicht gebildet, die als Diffusionssperrschicht nicht geeignet ist.

Auf der Membran ist auch im zweiten Ausführungsbeispiel ein Gassensoraufbau realisiert. In diesem Fall sind jedoch zur Vereinfachung der Herstellung die verschiedenen Elemente nebeneinander statt aufeinander realisiert. so führt in diesem Fall ein verkürzter Platinheizer 25 deutlich weniger weit in den Bereich der Membran hinein. Der verkürzte Platinheizer beansprucht 25 nur etwa die Hälfte der Membranfläche. Der verkürzte Platinheizer 25 ist wiederum bedeckt von einer Isolationsschicht 28. Neben dem verkürzten Platinheizer 25 führen wiederum zweite Gassensorelektroden 26 in den Bereich der Membran. Dort sind sie wiederum von einer Gassensorschicht 17 bedeckt. Im zweiten Ausführungsbeispiel dient die gute thermische Leitfähigkeit der Silizium-Membran zur Verteilung der Wärme auf der Membran und damit indirekt zur Beheizung des Gassensors. Dies stellt einen hinsichtlich der benötigten Prozesse deutlich vereinfachten Aufbau dar.

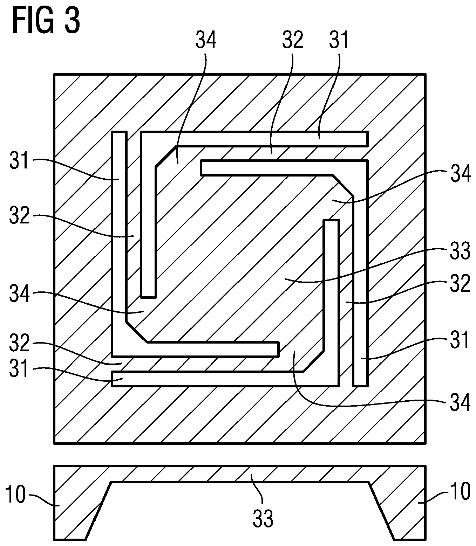

Figur 3 zeigt eine Draufsicht sowie einen Schnitt durch eine Strukturierung des Membransubstrats. Dabei ist wiederum der Rahmen 10 gezeigt, der das gesamte Membransubstrat umläuft. Im Rahmen 10 befindet sich die Membran 33. In der Draufsicht erkennt man, dass die Membran 33 nicht durchgängig mit dem Rahmen 10 verbunden ist. Vielmehr ist die Membran 33 an Stegen 32 aufgehängt. Die Stege 32, von denen bis vier gibt, beginnen dabei auf der Innenseite des Rahmens 10, und laufen parallel zur Innenkante des Rahmens 10, bis sie jeweils eine Abwinkelung 34 erreichen und sich dort mit der eigentlichen Membranfläche 33 verbinden. Um diese Strukturierung zu erreichen, weist das Substrat entsprechende Aussparungen 31 auf.

Da sehr hohe Temperaturunterschiede zwischen der Temperatur des Rahmens 10 und Betriebstemperatur vorkommen, muss der Längenausdehnung der Membran und dem entstehenden thermomechanischem Stress besondere Rechnung getragen werden. Dies geschieht durch die Aussparungen 31. Die Aussparungen gewährleisten eine federnde Aufhängung der Membran 33. Die Stege 32 nehmen mechanische Spannungen von der Membran 33 auf und verteilen diese über lange Federwege. Weiterhin agieren die Stege 32 selbstverständlich als Plattform für die elektrischen Zuleitungen auf die Membran 33.

Der gezeigte Aufbau erlaubt es, dass die hohen mechanischen Belastungen, die bei hohen Betriebstemperaturen auftreten, möglichst wenig zerstörerisch auf die Membran 33 wirken. Die mechanischen Belastungen ergeben sich dabei zum einen aus der hohen Differenz der Temperaturen zwischen dem Rahmen 10 und der Membran 33 und zum anderen aus unterschiedlichen thermischen Ausdehnungskoeffizienten zwischen den verschiedenen Materialien, aus denen die Membran 33 und die aufliegenden Schichten aufgebaut sind. Die unterschiedlichen Ausdehnungskoeffizienten führen dabei zu einer Verwölbung der Membran 33. Die federnde Aufhängung durch die Stege 32 erlaubt der Membran 33 dabei eine relativ weitgehende Verformung. Die Gesamtausdehnung, die die Membran 33 durch die hohe Betriebstemperatur erfährt, kann ebenfalls sehr gut von den Stegen 32 abgefedert werden, indem sich die Membran beispielsweise leicht in ihrer Aufhängung über die Stege 32 verdreht. Die kritischen Werte für die mechanischen Belastungen werden dabei auch bei sehr hohen Betriebstemperaturen von 800°C oder mehr nicht überschritten.

Ein besonderes Augenmerk ist bei den hohen Temperaturen im Betrieb auch auf die Haftung zwischen einzelnen Schichten des Aufbaus zu legen. Generell ist es notwendig, leitende Metallschichten aus beispielsweise Platin auf isolierendem Untergrund aus beispielsweise Siliziumdioxid mit guter Haftfestigkeit auch bei hohen Temperaturen aufzubringen. Da die Haftung von Platin auf SiO2 unzureichend ist, werden hierzu haftvermittelnde Schichten benötigt. Die klassischen metallischen Haftvermittler wie Ti, Cr, W, Ta als dünne metallische Schichten können hier nicht verwendet werden, da sie bei den hohen Temperaturen mit dem Pt legieren und auch nicht ausreichend oxidationsstabil sind. Hierzu werden vorteilhaft oxidische Haftvermittler verwendet, beispielsweise Schichten aus stöchiometrischen Oxiden. Diese Schichten sind bevorzugt zwischen 50 nm und 200 nm dick. Vorteilhaft können die oxidischen Haftvermittler weder nachoxidieren noch mit dem Platin legieren. Sehr gut geeignet sind hier beispielsweise das Ga₂O₃, beispielsweise als gesputterte Schicht, aber auch andere temperaturstabile Oxide, wie Al₂O₃, CeO₂, TiO₂ oder Zr₂O₃. Allerdings haben manche der Oxide den Nachteil, dass sie in das Ga₂O₃ der Gassensorschicht 17 wandern und dieses elektrisch dotieren können.

Es ist leicht ersichtlich, dass durch die beschriebenen Ausführungen ein Substrat dargestellt wird, das einen praktischen und kleinen Aufbau von leistungsfähigen Gassensoren mit einer Chipgröße von 1-2 mm² erlaubt. Die Heizleistung ist gegenüber herkömmlichen Substraten durch die starke thermische Isolation der Membran um etwa eine Größenordnung reduziert.

Weiterhin erlaubt die extrem kleine thermische Masse einen temperaturtransienten Betrieb der Sensoren, der im Zusammenhang mit einer entsprechenden Signalauswertung die Stabilisierung der Sensorgrundlinie und auch die Verbesserung der Gasdetektion (Selektivität bzw. Erkennung von Multigasgemischen) erlaubt. Die unkritische Biegeverformung führt gegenüber bekannten Lösungen mit überkritischem Scherstress zu einer erhöhten Lebensdauer.

Eine mögliche Prozessfolge zur Herstellung eines solchen Substrats kann wie folgt aussehen:
1. Ausgangsmaterial ist ein SOI-Wafer, wobei der sog. "Device Layer" der Membranschicht 13 entspricht und somit im Wesentlichen die Dicke der Membran ausmacht.
2. Abscheidung von Siliziumnitrid als Maske für eine Volumenätzung auf der Waferrückseite, z. B. durch einen CVD-Prozess und Strukturierung.
3. Abscheidung von Siliziumoxid als Isolatorschicht auf der Wafervorderseite, z. B. durch einen CVD-Prozess und Strukturierung.
4. Sputtern von Pt für die Heizerschicht 15, Strukturierung durch Fotolithographie und Ionenstrahlätzen.
5. Abscheidung von Siliziumoxid als Isolationsschicht 18, 28, z. B. durch einen CVD-Prozess und nachfolgende Strukturierung.
6. Trockenätzen des Silizium Device Layers, das SiO₂ dient hierbei als Maskierung.
7. KOH-Volumen-Ätzung des Wafers von der Rückseite zur Erzeugung der Membran; das Si3N4 dient hierbei als Maskierung.
8. Trockenätzen des SiO₂ von der Waferrückseite.
9. Sputtern von Ga₂O₃ für die Gassensorschicht 17 durch eine Schattenmaske.
10. Aufbringen eines porösen Katalysatorfilters durch einen Jetting/Dispens-Prozess.

Eine Verbesserung der Gassensitivität kann erreicht werden, indem die edelmetallhaltigen Zuleitungen wie die Heizerschicht 15, 25 und die Gassensorelektroden 16, 26 durch Passivierungsschichten, beispielsweise durch Glaspaste oder durch mittels CVD abgeschiedenes SiO2 abgedeckt werden. Dies verhindert den ungewünschten Umsatz der zu detektierenden Gase an den reaktiven, katalytisch aktiven Zuleitungen. Die Abdeckung der Zuleitungen ist auch vorteilhaft für den Einsatz in korrosiven industriellen Umgebungen und Abgasen.

Zur Verbesserung der Gasselektivität können auch zusätzliche poröse Dickschichten auf die Gassensorschicht 17 aufgebracht werden. Diese können einerseits als Filter zur Reduktion von Querempfindlichkeiten wirken, indem unerwünschte, störende Gase bereits bei der Diffusion durch die heiße poröse Dickschicht umgesetzt werden, diese die Gassensorschicht 17 nicht mehr erreichen und sie die Messung des eigentlichen Zielgases nicht mehr stören können. Als Dickschichtmaterial eignen sich oxidische Materialien wie Ga₂O₃, Al₂O₃. Andererseits können poröse Dickschichten auch einen aktivierenden Effekt auf das zu detektierende Zielgas haben. Bei der Diffusion durch die heiße poröse Dickschicht werden sonst reaktionsträge Moleküle aktiviert und ihr Messeffekt an der Gassensorschicht 17 gesteigert. Zur Aktivierung ist es erforderlich, ein Dickschichtmaterial mit aktivierenden Eigenschaften zu verwenden (z. B. Ga₂O₃).

Ein temperaturtransienter Betrieb der Sensoren mit multivariater Signalauswertung zur Verbesserung der Selektivität und Erkennung komplexer Geruchsmuster ist mit der erfindungsgemäßen Anordnung möglich, da die kleine thermische Masse einen schnellen Temperaturwechsel erlaubt.

## Patentansprüche

1. Substrataufbau mit
- einem Substrat, das wenigstens zwei separate Siliziumschichten (10, 13) aufweist und das in einem Teilbereich eine Membran (33) aufweist, wobei die Dicke der Membran (33) weniger als 200 µm beträgt, wobei die Membran (33) einen Teil einer ersten der Siliziumschichten (13) umfasst und die andere Siliziumschicht als Rahmen (10) ausgebildet ist, und
- wenigstens einer Diffusionssperrschicht (14, 19, 22) jeweils auf Ober- und Unterseite der ersten Siliziumschicht (13) zur Verminderung der Oxidation der ersten Siliziumschicht (13), wobei die Diffusionssperrschicht (14, 19, 22) wenigstens die Membran (33) bedeckt,
**gekennzeichnet durch:**
- dass die zwei Siliziumschichten einkristallin sind, und
- ein Beheizungselement (15, 25), das ausgestaltet ist, in wenigstens einem Teil der Membran (33) eine Temperatur von mehr als 650°C zu erzeugen.

2. Substrataufbau gemäß Anspruch 1, bei dem die Diffusionssperrschicht (14, 19, 22) eins oder mehrere der folgenden Materialien umfasst:
- Platin,
- Platinsilizid,
- Siliziumnitrid,
- Siliziumkarbid.

3. Substrataufbau gemäß einem der vorangehenden Ansprüche, bei dem die Membran (33) mit dem Rest des Substrats über Stege (32) verbunden ist.

4. Substrataufbau gemäß Anspruch 3, bei dem die Stege (32) jeweils wenigstens eine Abwinkelung (34) aufweisen.

5. Substrataufbau gemäß einem der vorangehenden Ansprüche, bei dem als haftvermittelnde Schicht zwischen dem Beheizungselement (15, 25) oder einer anderen metallischen Schicht (16, 26) und einer unterliegenden isolierenden Schicht (14, 18) eine Schicht vorgesehen ist, die im Wesentlichen aus einem Metalloxid besteht.

6. Substrataufbau gemäß einem der vorangehenden Ansprüche mit einem gassensitiven Element (17), das wenigstens zum Teil auf der Membran (33) aufgebracht ist.

7. Verfahren zur Herstellung eines Substrataufbaus, bei dem
- ein Substrat mit wenigstens zwei separaten Siliziumschichten (10, 13) bereitgestellt wird,
- in einem Teilbereich des Substrats eine Membran (33) erzeugt wird, deren Dicke weniger als 200 µm beträgt, wobei die Membran (33) einen Teil einer ersten der Siliziumschichten (13) umfasst und die andere Siliziumschicht als Rahmen (10) ausgebildet ist, und
- eine Diffusionssperrschicht (14, 19, 22) jeweils auf Ober-und Unterseite der ersten Siliziumschicht (13) zur Verminderung der Oxidation der ersten Siliziumschicht (13) erzeugt wird, wobei die Diffusionssperrschicht (14, 19, 22) wenigstens die Membran (33) bedeckt,
**dadurch gekennzeichnet, dass**
- dass die zwei Siliziumschichten einkristallin sind, und
- ein Beheizungselement (15, 25) erzeugt wird, das ausgestaltet ist, in wenigstens einem Teil der Membran (33) eine Temperatur von mehr als 650°C zu erzeugen.

8. Verfahren gemäß Anspruch 7, bei dem ein Silicon-on-Insulator-Wafer als Substrat verwendet wird.

## Claims

1. Substrate construction comprising
- a substrate, which has at least two separate silicon layers (10, 13) and which has a membrane (33) in a partial region, wherein the thickness of the membrane (33) is less than 200 µm, wherein the membrane (33) comprises a part of a first of the silicon layers (13) and the other silicon layer is formed as a frame (10), and
- at least one diffusion barrier layer (14, 19, 22) in each case on the top side and underside of the first silicon layer (13) for reducing the oxidation of the first silicon layer (13), wherein the diffusion barrier layer (14, 19, 22) covers at least the membrane (33),
**characterized by**
- that the two silicon layers are monocrystalline, and
- a heating element (15, 25), which is designed to generate a temperature of more than 650°C in at least one part of the membrane (33).

2. Substrate construction according to Claim 1, wherein the diffusion barrier layer (14, 19, 22) comprises one or more of the following materials:
- Platinum,
- Platinum silicide,
- Silicon nitride,
- Silicon carbide.

3. Substrate construction according to either of the preceding claims, wherein the membrane (33) is connected to the rest of the substrate via webs (32).

4. Substrate construction according to Claim 3, wherein the webs (32) each have at least one angled portion (34).

5. Substrate construction according to any of the preceding claims, wherein a layer substantially consisting of a metal oxide is provided as adhesion-promoting layer between the heating element (15, 25) or some other metallic layer (16, 26) and an underlying insulating layer (14, 18).

6. Substrate construction according to any of the preceding claims comprising a gas-sensitive element (17), which is applied at least partly on the membrane (33).

7. Method for producing a substrate construction, wherein
- a substrate having at least two separate silicon layers (10, 13) is provided,
- a membrane (33) is produced in a partial region of the substrate, the thickness of said membrane being less than 200 µm, wherein the membrane (33) comprises a part of a first of the silicon layers (13) and the other silicon layer is formed as a frame (10), and
- a diffusion barrier layer (14, 19, 22) in each case on the top side and underside of the first silicon layer (13) for reducing the oxidation of the first silicon layer (13) is produced, wherein the diffusion barrier layer (14, 19, 22) covers at least the membrane (33),
**characterized in that**
- that the two silicon layers are monocrystalline, and
- a heating element (15, 25) is produced, which is designed to generate a temperature of more than 650°C in at least one part of the membrane (33).

8. Method according to Claim 7, wherein a silicon-on-insulator wafer is used as substrate.

## Revendications

1. Structure faisant office de substrat comprenant :
- un substrat qui présente au moins deux couches de silicium séparées (10, 13) et qui présente une membrane (33) dans une zone partielle ; dans laquelle l'épaisseur de la membrane (33) est inférieure à 200 µm ; dans laquelle la membrane (33) comprend une partie d'une première couche choisie parmi les couches de silicium (13), tandis que l'autre couche de silicium est réalisée sous la forme d'un encadrement (10) ; et
- au moins une couche faisant office de barrière à la diffusion (14, 19, 22) respectivement sur le côté supérieur et sur le côté inférieur de la première couche de silicium (13), destinée à réduire l'oxydation de la première couche de silicium (13) ; dans laquelle la couche faisant office de barrière à la diffusion (14, 19, 22) recouvre au moins la membrane (33) ;
**caractérisée**
- **par le fait que** les deux couches de silicium sont de type monocristallin ; et
- par un élément de chauffage (15, 25) qui est conçu pour générer dans au moins une partie de la membrane (33) une température supérieure à 650 °C.

2. Structure faisant office de substrat selon la revendication 1, dans laquelle la couche faisant office de barrière à la diffusion (14, 19, 22) comprend une ou plusieurs matières choisies parmi les matières suivantes :
- du platine ;
- du siliciure de platine ;
- du nitrure de silicium ;
- du carbure de silicium.

3. Structure faisant office de substrat selon l'une quelconque des revendications précédentes, dans laquelle la membrane (33) est reliée au reste du substrat via des entretoises (32).

4. Structure faisant office de substrat selon la revendication 3, dans laquelle les entretoises (32) présentent respectivement au moins une partie coudée (34).

5. Structure faisant office de substrat selon l'une quelconque des revendications précédentes, dans laquelle, à titre de couche favorisant l'adhérence entre l'élément de chauffage (15, 25) ou une autre couche métallique (16, 26) et une couche isolante sous-jacente (14, 18), on prévoit une couche qui est constituée essentiellement d'un oxyde métallique.

6. Structure faisant office de substrat selon l'une quelconque des revendications précédentes, comprenant un élément (17) sensible aux gaz qui est appliqué au moins en partie sur la membrane (33).

7. Procédé pour la fabrication d'une structure faisant office de substrat, dans lequel :
- on procure un substrat comprenant au moins deux couches de silicium séparées (10, 13) ;
- dans une zone partielle du substrat, on génère une membrane (33) dont l'épaisseur est inférieure à 200 µm ; dans lequel la membrane (33) comprend une partie d'une première couche choisie parmi les couches de silicium (13) tandis que l'autre couche de silicium est réalisée sous la forme d'un encadrement (10) ; et
- on génère une couche faisant office de barrière à la diffusion (14, 19, 22), respectivement sur le côté supérieur et sur le côté inférieur de la première couche de silicium (13), destinée à réduire l'oxydation de la première couche de silicium (13) ; dans laquelle la couche faisant office de barrière à la diffusion (14, 19, 22) recouvre au moins la membrane (33) ;
**caractérisé en ce que**
- les deux couches de silicium sont de type monocristallin ; et
- on génère un élément de chauffage (15, 25), qui est conçu d'une manière telle que l'on obtient dans au moins une partie de la membrane (33) une température supérieure à 650 °C.

8. Procédé selon la revendication 7, dans lequel on utilise, à titre de substrat, une tranche de silicium sur isolant.
